# EUROPEAN PATENT APPLICATION

(11) **EP 1 799 018 A2**
(43) Date of publication of application: **20.06.2007**
(21) Application number: 06026092.4
(22) Date of filing: 15.12.2006
(51) Int. Cl.: H05K 1/00, H05K 1/14, H05K 3/36, H05K 3/46, H01R 12/04

(54) **Electrical circuit board, board device, motor, motor device, electric pump, and method of connecting motor and electrical circuit board or board device**

(30) Priority: 19.12.2005 JP 2005365494
(71) Applicant: JTEKT CORPORATION, Chuo-ku Osaka-shi Osaka 542-8502 (JP); KOYO ELECTRONICS INDUSTRIES CO., LTD., Kodahira-shi Tokyo 187-0004 (JP)
(72) Inventor: Okumura, Shigekazu, Osaka-shi Osaka 542-8502 (JP); Itou, Daigo, Tokyo 187-0004 (JP)
(74) Representative: Schaeberle, Steffen

(57) **Abstract**

A print board that is to be connected to a motor includes a wiring layer in which a driving current flows. A bolting through hole is provided close to the wiring layers. Meanwhile, a power terminal of the motor is in the form of nuts. A bolt is inserted into the through hole and is threaded into the power terminal.

## Description

### BACKGROUND OF THE INVENTION

The present invention relates to a motor, an electrical circuit board having provided thereon a driving circuit for driving a motor, a board device using a plurality of electrical circuit boards, a motor device, an electric pump, and a method of connecting a motor and an electrical circuit board or a board device.

A brushless motor includes a stator coil and a magnet rotor. The brushless motor is supplied with an AC driving current, and generates a rotation magnetic field by the stator coil so as to rotate the magnet rotor. A driving circuit generates the driving current, for example, by a PWM (Pulse Width Modulation) control method. The driving circuit is configured by forming a wiring pattern on an electrical circuit board and mounting circuit parts, such as a FET (Field Effect Transistor), a diode, or the like thereon.

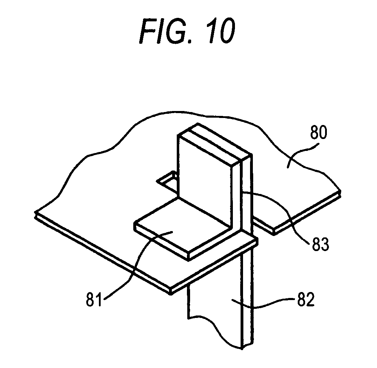

An electric pump is used to generate a hydraulic pressure for assisting steering of a hydraulic power steering device of a vehicle. As a driving source, for example, a brushless motor is used. As shown in Fig. 10, in a known electric pump, a power terminal 82 of the brushless motor and a terminal 81 of a print board 80 are connected to each other at a joint 83 by soldering or welding (for example, see JP-A-2004-353537).

As known method of connecting the brushless motor and the print board, the power terminal of the brushless motor is soldered or welded to the terminal of the print board. However, simplification is more needed.

In the known electric pump, the driving circuit is provided on a single print board, but there may be a case where the area of the print board needs to be reduced according to a housing for accommodating the brushless motor and the print board therein.

In particular, with high capacity of the brushless motor, circuit parts constituting the driving circuit are increased in size to handle a large current (high capacity), and thus the print board is increased in size. Print boards having different sizes and shapes are needed according to the capacity of the brushless motor. Upon mass production of electric pump having various capacities, electrical circuit boards need to be provided and managed according to the capacity of the brushless motor.

### SUMMARY OF THE INVENTION

The invention has been made in consideration of the above problems, and an object of the invention is to provide an electrical circuit board that simplifies the connection to a motor.

Another object of the invention is to provide an electrical circuit board that improves convenience when circuit parts are mounted on opposite sides.

still another object of the invention is to provide a board device that can allow the electrical circuit board to have the size and shape suitable for the size and shape of a motor and can allow the large motor to be driven using the plurality of driving circuits for the small motors, and provide a board device in which supply and manage of electrical circuit boards are simplified upon mass production of various motor devices or electric pumps.

Yet still another object of the invention is to provide a motor that can simplify connection to an electrical circuit board.

Yet still another object of the invention is to provide a motor device and an electric pump that can simplify connection and disconnection to and from an electrical circuit board.

Yet still another object of the invention is to provide a method of connecting a motor and an electrical circuit board or a board device that can realize ease of manufacturing.

In order to solve the above problems, the present invention is characterized by having the following arrangements.
(1) An electrical circuit board to be connected to a motor, the electrical circuit board comprising:
   wiring layers in which a current for driving a motor flows; and
   a bolting through hole provided close to the wiring layers.
(2) The electrical circuit board according to (1),
   wherein the wiring layers are provided on opposite sides of the electrical circuit board.
(3) A board device comprising:
   a plurality of electrical circuit boards according to (2) that are arranged so that a bolting through hole of one of the plurality of electrical circuit boards is coaxially arranged with a bolting through hole of the other electrical circuit board; and
   a conductive spacer arranged between the plurality of electrical circuit boards,
   wherein opposite ends of the spacer are respectively connected to the wiring layers of the plurality of electrical circuit boards spaced apart from each other by the spacer.
(4) A motor comprising;
   a power terminal in the form of a nut.
(5) A motor device comprising:
   an electrical circuit board according to (1);
   a motor including a power terminal in the form of a nut; and
   a bolt threaded into the nut via a through hole of the electrical circuit board.
(6) A motor device comprising:
   a board device according to (3);
   a motor that has a power terminal in the form of a nut; and
   a bolt threaded into the nut via through holes of electrical circuit boards of the board device.
(7) An electric pump comprising:
   an electrical circuit board according to (1);
   a motor including a power terminal in the form of a nut;
   a bolt threaded into the nut via a through hole of the electrical circuit board; and
   a pump driven by the motor.
(8) An electric pump comprising:
   the board device according to (3);
   a motor that has a power terminal in the form of a nut;
   a bolt threaded into the nut via through holes of electrical circuit boards of the board device; and
   a pump driven by the motor.
(9) A method of connecting a motor including a power terminal in the form of a nut and an electrical circuit board according to (1), the method comprising:
   inserting a bolt into the through hole of the electrical circuit board; and
   threading the bolt into the nut.
(10) A method of connecting a motor including a power terminal in the form of a nut and a board device according to (3), the method comprising:
   inserting a bolt via the through holes of the electrical circuit boards of the board device; and
   threading the bolt into the nut.

According to the invention, the through holes are respectively provided at positions close to the wiring layers, in which the driving current flows. Then, when the conductive bolts are respectively fastened to the motor via the through holes, the bolts are connected to the wiring layers, such that the driving current is supplied to the motor via the bolts. Accordingly, the connection of the electrical circuit board and the motor is simplified. Further, since the bolts fix the electrical circuit board and the motor, a manufacturing process of an electric pump can be simplified, and an electric pump can be reduced in size. In addition, the bolts are easily removed, and thus a time required for replacing and repairing an electrical circuit board and a motor is reduced.

According to the invention, the wiring layers are provided on opposite sides of the electrical circuit board. Therefore, circuit parts can be easily mounted on opposite sides of the electrical circuit board and connected to the wiring layers.

According to the invention, the board device has the plurality of electrical circuit boards that are provided in parallel to be spaced at a predetermined interval by the spacers formed of the conductive material. The wiring layers of the electrical circuit board spaced apart from each other by the spacers are connected to each other via the spacers. When the driving circuit is increased in size with the high capacity of the motor, the board device can have the plurality of electrical circuit boards that are provided in parallel. Accordingly, when the motor and the electrical circuit board are accommodated in a housing, a plurality of electrical circuit boards having a small area are accommodated in the housing. Further, driving of a high-capacity motor can be performed by connecting a plurality of driving circuits for a low-capacity motor in parallel. Therefore, upon mass production of the motor device or the electric pump, the electrical circuit board can be simply provided and managed.

According to the invention, the power terminals of the motor are in the form of the nuts. Accordingly, when the conductive bolts are fastened to the nuts via the through holes of the electrical circuit board, the driving current is supplied from the electrical circuit board to the motor via the bolts. Therefore, the connection of the electrical circuit board and the motor is simplified. Further, since the bolts fix the electrical circuit board and the motor, a manufacturing process can be simplified and the electric pump can be reduced in size. In addition, the bolts can be simply removed, and thus the time required for replacing and repairing the electrical circuit board and the motor can be reduced.

According to the invention, the electrical circuit board is simply connected to the motor by inserting the bolts into the through holes of the electrical circuit board or the board device to be fastened to the nuts of the motor, thereby forming the motor device. Further, the bolts can be simply removed, and thus a time required for replacing and repairing the motor and the electrical circuit board can be reduced.

According to the invention, in the electric pump, the motor and the electrical circuit board are connected to each other by isnerting the bolts into the through holes of the electrical circuit board to be fastened to the nuts of the motor. Further, the electric pump has the pump driven by the motor. Accordingly, the connection of the motor and the electrical circuit board are simplified, and thus the electric pump can be simply manufactured. In addition, since the motor and the electrical circuit board are fixed to each other by bolting, a manufacturing process can be simplified, and the electric pump can be reduced in size.

### BRIEF DESCRIPTION OF THE DRAWINGS

Fig. 1 is a perspective view of a brushless motor according to a first embodiment of the invention.
Fig. 2 is a perspective view of a print board according to the first embodiment of the invention.
Fig. 3 is a longitudinal cross-sectional view of an electric pump according to the first embodiment of the invention.
Fig. 4 is an enlarged view showing a state where the brushless motor and the print board are connected to each other.
Fig. 5 is a perspective view of a board device according to a second embodiment of the invention.
Fig. 6 is a longitudinal cross-sectional view of an electric pump according to the second embodiment of the invention.
Fig. 7 is a circuit diagram showing a state where power MOSFETs are connected in parallel.
Fig. 8 is an explanatory view schematically showing essential parts of a hydraulic power steering device of a vehicle according to a third embodiment of the invention.
Fig. 9 is a block diagram showing the configuration of a driving circuit.
Fig. 10 is a partial enlarged view of a known electric pump.

### DETAILED DESCRIPTION OF PREFERRED EMBODIMENTS

Hereinafter, embodiments in which the invention is applied to a brushless motor will be described with reference to the drawings.

### <First Embodiment>

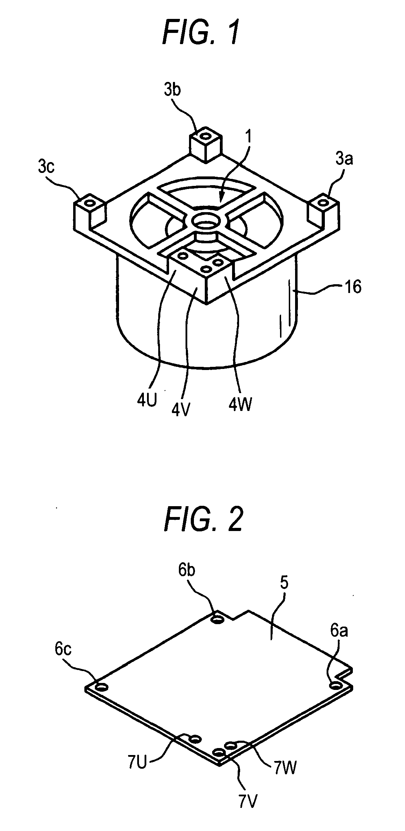

A first embodiment of the invention will be described with reference to Figs. 1 to 4. Fig. 1 is a perspective view of a brushless motor of the embodiment.

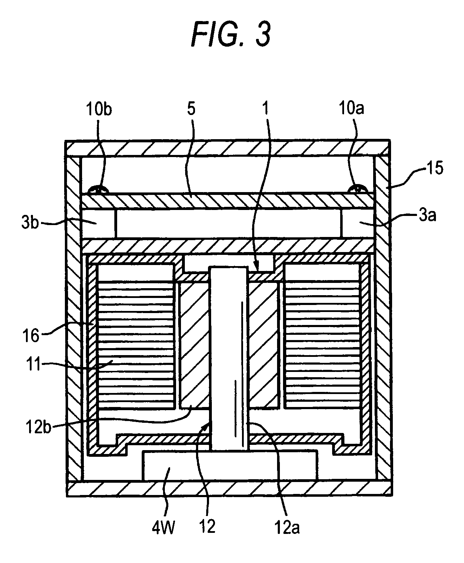

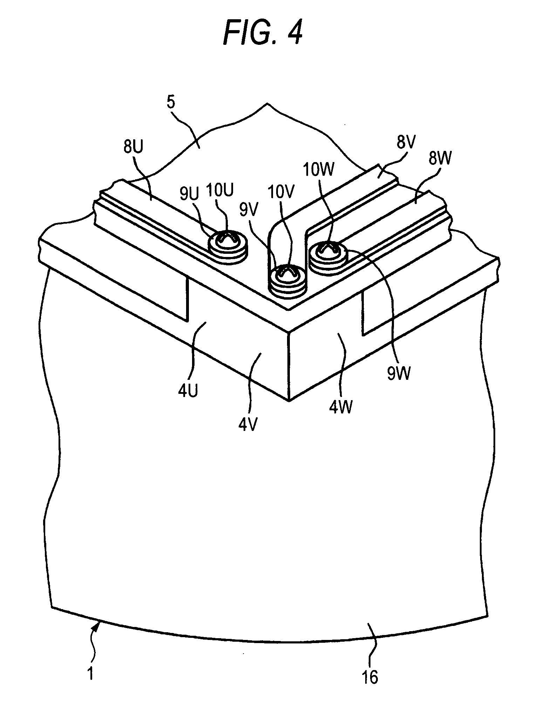

Fig. 2 is a perspective view of a print board on which a driving circuit of the brushless motor is provided. Fig. 3 is a longitudinal cross-sectional view of an electric pump having the brushless motor. Fig. 4 is an enlarged view showing a wiring structure in which the brushless motor and the print board are connected to each other.

A brushless motor 1 includes a ring-shaped stator coil 11, and a magnet rotor 12 located inside the stator coil 11. The magnet rotor 12 has a rotary shaft 12a, and a magnet 12b externally fitted to the rotary shaft 12a.

The brushless motor 1 is surrounded by a cylindrical case 16 having a bottom. The rotary shaft 12a is inserted into both bottoms of the cylinder so as to axially support the cylinder. At one bottom, power terminals 4U, 4V and 4W and nuts 3a, 3b, and 3c are provided.

The nuts 3a, 3b, and 3c are provided at three corners of a square at one end of the case 16, respectively, so as to connect the brushless motor 1 and a print board 5. At a remaining corner, three-phase power terminals 4U, 4V, and 4W in the form of nuts are provided. A line connecting the power terminals 4U and 4V and a line connecting the power terminals 4V and 4W are at right angle with the power terminal 4V as a corner.

The electric pump is configured by connecting the brushless motor 1 and the print board 5, on which the driving circuit is provided by mounting the wiring layers and the circuit parts thereon, by conductive bolts 10a, 10b, 10U, 10V and 10W. An operating shaft of a gear pump 14 is connected to the rotary shaft 12a of the brushless motor 1. The brushless motor 1, the print board 5 and the gear pump 14 are accommodated in the housing 15.

As shown in Fig. 2, in the print board 5, two adjacent corners are cut out in a rectangular shape, and bolting through holes 6a, 6b and 6c are provided near both cutouts and one of two uncut corners, respectively. Through holes 7U, 7V and 7W are provided at the other corner of the two uncut corners.

In the print board 5, the through holes 6a, 6b and 6c are provided at positions where the bolts can be inserted and be fastened to the nuts 3a, 3b and 3c of the brushless motor 1, respectively. The through holes 7U, 7V and 7W are provided at positions where the bolts can be inserted and be fastened to the power terminals 4U, 4V and 4W of the brushless motor 1, respectively.

Moreover, required wiring patterns including wiring layers 8U, 8V and 8W, through which a three-phase driving current flows, are provided on opposite sides of the print board 5. Next, circuit parts, such as a FET, a diode, and the like, are mounted on opposite sides of the print board 5, thereby forming the driving circuit. The driving circuit generates a three-phase driving current, for example, in a PWM control method. The print board 5 is connected to the brushless motor 1 by bolting.

As shown in Fig. 3, the bolts 10a, 10b and 10c (not shown) are fastened to the nuts 3a, 3b and 3c provided in the brushless motor 1 via the through holes 6a, 6b and 6c of the print board 5, respectively. The rotary shaft 12a is connected to the operating shaft of the gear pump 14. The gear pump 14 operates according to the rotation of the rotary shaft 12a, such that a fluid is delivered.

As shown in Fig. 4, the print board 5 is provided such that the through holes 7U, 7V and 7W overlap the power terminals 4U, 4V and 4W, respectively. On a front surface of the print board 5, the wiring layers 8U, 8V and 8W through which the three-phase driving current flows come into contact with the through holes 7U, 7V and 7W, respectively. The wiring layers 8U, 8V and 8W are also provided on a rear surface of the print board 5.

The bolts 10U, 10V and 10W are inserted into the through holes 7U, 7V and 7W via metal washers 9U, 9V and 9W and fastened to the power terminals 4U, 4V and 4W, respectively. Since the wiring layers 8U, 8V and 8W come into contact with the through holes 7U, 7V and 7W, respectively, the wiring layers 8U, 8V and 8W, the metal washers 9U, 9V and 9W, and the bolts 10U, 10V, and 10W are conducted to one another, respectively.

The bolts 10U, 10V and 10W are fastened to the power terminals 4U, 4V and 4W, respectively. Accordingly, the wiring layers 8U, 8V and 8W are conducted to the power terminals 4U, 4V and 4W via the metal washers 9U, 9V and 9W and the bolts 10U, 10V and 10W, respectively.

As described above, in this embodiment, the power terminals 4U, 4V and 4W of the brushless motor 1 and the wiring layers 8U, 8V and 8W of the print board 5 are conducted to each other by the bolts 10U, 10V and 10W, respectively. Therefore, soldering or welding required for manufacturing a known electric pump is unnecessary, and thus an electric pump is simply manufactured.

Since the bolts 10U, 10V and 10W fix the brushless motor 1 and the print board 5, a manufacturing process is simplified, and manufacturing costs are reduced. Further, the electric pump is reduced in size.

In addition, since the fastened bolts 10U, 10V and 1OW can be simply removed, after the brushless motor 1 and the print board 5 are connected to each other, the brushless motor 1 and the print board 5 can be disconnected from each other by removing the bolts 10U, 10V and 10W. Accordingly, replacement and repair of the brushless motor 1 and the print board 5 can be simply performed. Therefore, a time required for replacement and repair is reduced.

Although the circuit parts are mounted on opposite sides of the print board 5 in this embodiment, the circuit parts may be mounted on one side of the print board 5.

In this embodiment, the wiring layers 8U, 8V and 8W come into contact with the through holes 7U, 7V and 7W, respectively. Alternatively, the wiring layers 8U, 8V and 8W may not come into contact with the through holes 7U, 7V and 7W, respectively. In this case, when the bolts 10U, 10V and 10W are fastened to the power terminals 4U, 4V and 4W via the metal washers 9U, 9V and 9W and the through holes 7U, 7v and 7W, respectively, the wiring layers 8U, 8V and 8W and the blots 10U, 10V and 10W are connected to each other.

In addition, although the brushless motor is used in this embodiment, various motors may be used. In this case, power terminals are in the form of nuts, and a driving current is supplied from the print board to the power terminals via the bolts. With this configuration, the connection of the motor and the print board is simplified.

### <Second Embodiment>

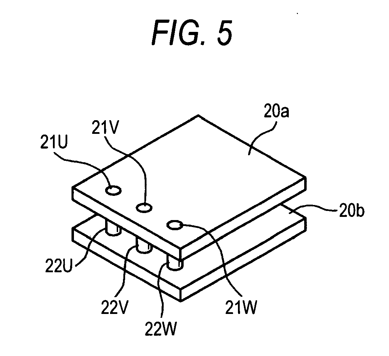

A second embodiment of the invention will be described with reference to Figs. 5 to 7. Fig. 5 is a perspective view of a board device, on which a driving circuit for a high-capacity brushless motor having a capacity two times as much as the capacity of a low-capacity brushless motor. The board device has two print boards 20a and 20b. As shown in Fig. 5, the print boards 20a and 20b have the same size and shape.

The print boards 20a and 20b are coaxially provided in parallel around three-phase through holes 21U, 21V and 21W and are spaced apart from each other by conductive spacers 22U, 22V and 22W. Power terminals of a high-capacity brushless motor 1a are in the form of nuts. The through holes 21U, 21V and 21W are provided at positions where the bolts can be inserted into and fastened to the power terminals.

Wiring patterns including wiring layers in which a three-phase driving current flows are formed on opposite sides of the print boards 20a and 20b and circuit parts such as a FET, a diode and the like, are mounted thereon, thereby forming driving circuits for a low-capacity brushless motor. The wiring layers in which the three-phase driving current flows come into contact with the through holes 21U, 21V and 21W, respectively.

Opposite ends of each of the spacers 22U, 22V and 22W are connected to the wiring layers of the print boards 20a and 20b via a conductive coating material. The print boards 20a and 20b are connected in parallel so as to form the board device, and the board device drives the brushless motor having a capacity two times as much as the capacity of a low-capacity brushless motor.

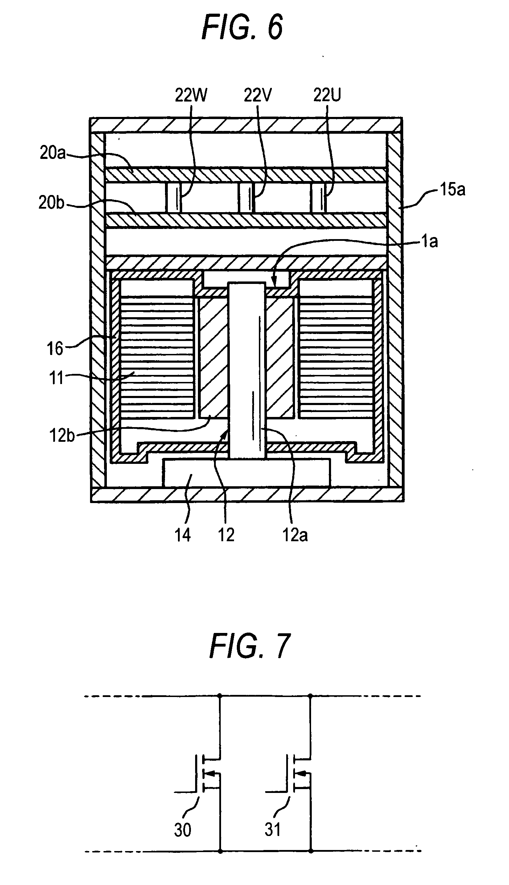

Fig. 6 is a longitudinal cross-sectional view of an electric pump that uses a high-capacity brushless motor. The electric pump is configured by connecting the high-capacity brushless motor 1a, the board device having the two print boards 20a and 20b, and the gear pump 14, and accommodating them in a housing 15a. Moreover, in Fig. 6, the parts corresponding to the electric pump shown in Fig. 3 are represented by the same reference numerals, and the descriptions thereof will be omitted.

In this embodiment, the two print boards 20a and 20b are provided in parallel to be spaced apart from each other by the spacers 22U, 22V and 22W. Accordingly, an area enough to mount the circuit parts constituting the driving circuit, such as a FET, a diode, and the like, is secured. Therefore, the driving circuits can be provided on the print boards 20a and 20b.

Further, as shown in Fig. 7, in order to supply a driving current to the high-capacity brushless motor, N-channel power MOSFETs (Metal-Oxide-Semiconductor FET) may be connected in parallel, and power MOSFETs 30 and 31 may be controlled at the same time.

Two print boards 20a for a low-capacity brushless motor, on which a driving circuit for a low-capacity brushless motor is provided, are connected in parallel, thereby forming the board device shown in Fig. 5. Accordingly, a driving circuit for a high-capacity brushless motor can be obtained.

Similarly, three or more print boards 20a for a low-capacity brushless motor may be connected in parallel by conductive spacers, thereby forming a board device. Accordingly, a high-capacity brushless motor can be driven.

In this embodiment, driving circuits for brushless motors having the same capacity are provided on the print boards 20a and 20b. However, driving circuits for brushless motors having different capacities may be provided, and the conduction between them may be made by conductive spacers. According to different capacities, the print boards may have different size and shape.

### <Third Embodiment>

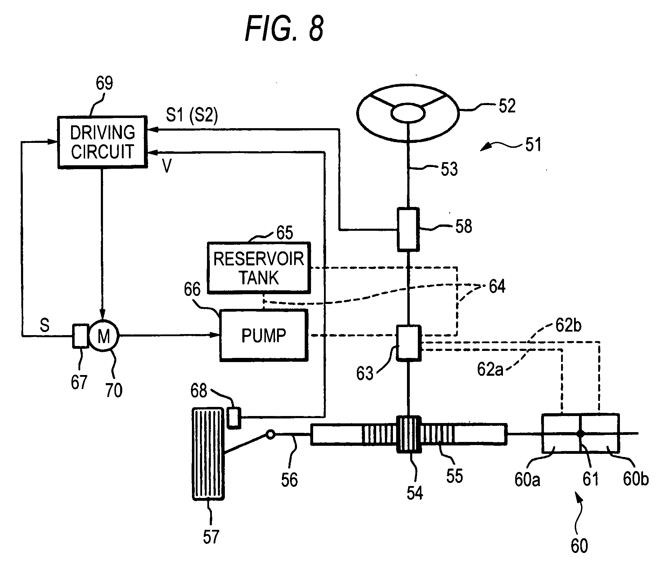

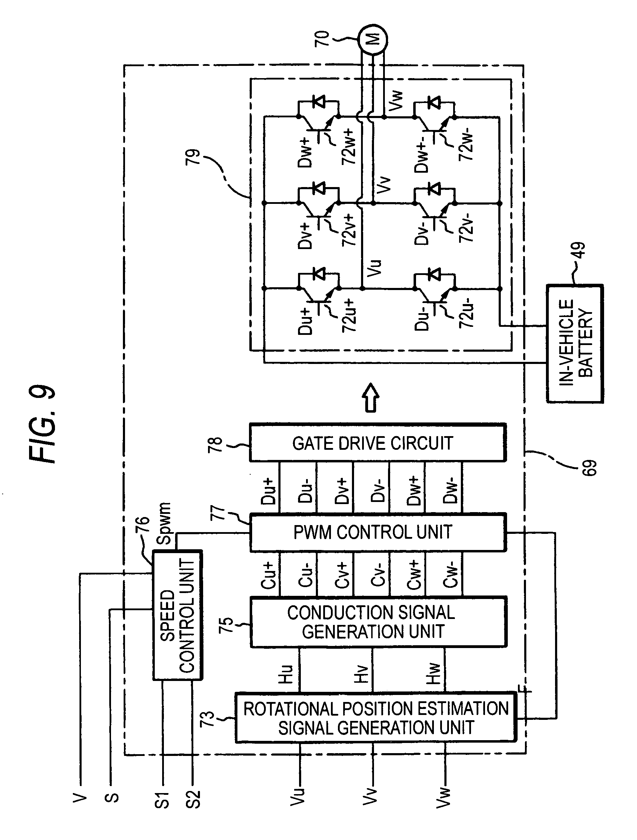

A third embodiment of the invention will be described with reference to Figs. 8 and 9. Fig. 8 is an explanatory view schematically showing essential parts of a hydraulic power steering device of a vehicle. The hydraulic power steering device assists steering of a steering mechanism 51 of the vehicle.

The steering mechanism 51 has a steering wheel 52, a steering shaft 53 that is connected to the steering wheel 52, a pinion 54 that is attached to a front end of the steering shaft 53, a rack shaft 55 that extends in a widthwise direction of the vehicle and is meshed with the pinion, a tie rod 56 that is attached to the rack shaft 55, and a front tire 57 that is attached to the tie rod 56.

A piston 61 of a power cylinder 60 is connected to the rack shaft 55. The power cylinder 60 has a pair of cylinder chambers 60a and 60b that are defined by the piston 61. The cylinder chambers 60a and 60b are connected to a hydraulic pressure control valve 63 via oil supply paths 62a and 62b, respectively.

The hydraulic pressure control valve 63 is connected to a part of an oil circulation path 64. A degree of opening of the hydraulic pressure control valve 63 changes according to the direction and size of torque applied to the steering shaft 53 by a steering operation of the steering wheel 52. A pump 66 operates by a brushless motor 70 so as to lave a hydraulic oil stored in a reservoir tank 65, circulate through the oil circulation path 64, and return to the reservoir tank 65.

A vehicle speed sensor 68 detects a rotation speed of the front tire 57. The vehicle speed sensor 68 is a magnetic sensor that detects a magnetic metal piece fixed to the front tire 57. Further, the vehicle speed sensor 68 may be an optical sensor that optically detects a hole provided in the front tire 57. A vehicle speed signal V that is a detection signal of the vehicle speed sensor 68 is supplied to a driving circuit 69.

A rotation speed sensor 67 detects a rotation speed of the brushless motor 70 and outputs the detected rotation speed S to the driving circuit 69. A steering angle sensor 58 is a rotary encoder that detects a steering angle of the steering wheel 52. The steering angle sensor 58 is attached to the steering shaft 53. The steering angle sensor 58 outputs edge signals S1 and S2 of the rotary encoder to the driving circuit 69.

The driving circuit 69 generates a driving current for driving the brushless motor 70 on the basis of the vehicle speed signal V supplied from the vehicle speed sensor 68, the rotation speed S supplied from the rotation speed sensor 67, and the edge signals S1 and S2 supplied from the steering angle sensor 58, and output the driving current to the brushless motor 70.

The driving circuit 69, the brushless motor 70, and the pump 66 correspond to the electric pump of the first embodiment. Further, they may correspond to the electric pump of the second embodiment.

when the steering wheel 52 operates, torque is transferred to the steering shaft 53, and the pinion 54 rotates. With the rotation of the pinion 54, the rack shaft 55 moves in the widthwise direction of the vehicle. The movement amount of the rack shaft 55 is transferred to the tie rod 56, and the direction of the front tire 57 changes.

Simultaneously, the hydraulic pressure control valve 63 changes the degree of opening according to the torque transferred to the steering shaft 53, and supplies the hydraulic oil to one of the cylinder chambers 60a and 60b of the power cylinder 60. The cylinder 61 moves in the widthwise direction of the vehicle by the hydraulic oil supplied to one of the cylinder chambers 60a and 60b, and assists the movement of the rack shaft 55.

On the basis of the vehicle speed signal V supplied from the vehicle speed sensor 68, the driving circuit 69 increases the rotation speed of the brushless motor 70 at the time of a low speed so as to increase an assistance force. Meanwhile, the driving circuit 69 decreases the rotation speed of the brushless motor 70 at the time of a high speed so as to decrease the assistance force. Further, as a steering speed becomes faster on the basis of the edge signals S1 and S2 supplied from the steering angle sensor 58, the driving circuit 69 increases the rotation speed of the brushless motor 70 so as to increase the assistance force.

Fig. 9 is a block diagram showing the configuration of the driving circuit 69. Terminal voltages Vu, Vv, and Vw of the stator coil 11 of U-, V-, and W-phases (see Fig. 3) of the brushless motor 70 are supplied to a rotational position estimation signal generation unit 73. The rotational position estimation signal generation unit 73 generates rotational position estimation signals Hu, Hv, and Hw for the individual phases on the basis of the supplied terminal voltages through sampling, and outputs the rotational position estimation signals Hu, Hv, and Hw to a conduction signal generation unit 75. Further, the rotational position estimation signal generation unit 73 outputs a phase signal F indicating a timing of a zero cross point of one phase of the voltages Vu, Vv, and Vw to a PWM control unit 77.

The conduction signal generation unit 75 generates conduction signals Cu+, Cu-, Cv+, Cv-, Cw+ and Cw- on the basis of the rotational position estimation signals Hu, Hv and Hw for the individual phases supplied from the rotational position estimation signal generation unit 73 and outputs the conduction signals Cu+, Cu-, Cv+, Cv-, Cw+ and Cw- to the PWM control unit 77. The conduction signal generation unit 75 has an MPC (Micro Processing Unit) or a logical element.

A speed control unit 76 determines the rotation speed of the brushless motor 70 on the basis of the rotation speed S supplied from the rotation speed sensor 67, the vehicle speed signal v supplied from the vehicle speed sensor 68, and the edge signals S1 and S2 supplied from the steering angle sensor 58, and outputs a speed control signal Spwm to the PWM control unit 77.

The PWM control unit 77 generates PWM control signals Du+, Du-, Dv+, Dv-, Dw+ and Dw- for respectively controlling semiconductor switching elements (NPN bipolar transistors) 72u+, 72u-, 72v+, 72v-, 72w+ and 72w- on the basis of the conduction signals Cu+, Cu-, Cv+, Cv-, Cw+ and Cw- supplied from the conduction signal generation unit 75, the speed control signal Spwm supplied from the speed control unit 76, and the phase signal F supplied from the rotational position estimation signal generation unit 73, and supplies the PWM control signals Du+, Du-, Dv+, Dv-, Dw+ and Dw- to a gate drive circuit 78.

The gate drive circuit 78 turns on/off the semiconductor switching elements 72u+, 72u-, 72v+, 72v-, 72w+ and 72w- on the basis of the PWM control signals Du+, Du-, Dv+, Dv-, Dw+ and Dw- supplied from the PWM control unit 77.

In a switching circuit 79, the semiconductor switching elements 72u+, 72v+ and 72w+ connected to an anode of an in-vehicle battery 49 and the semiconductor switching elements 72u-, 72v- and 72w- connected to a cathode of the in-vehicle battery 49 are connected to each other in series for the U, V and W phases, respectively.

Connection points between the semiconductor switching elements are respectively connected to the power terminals 4U, 4V and 4W of the brushless motor 70. Freewheel diodes are respectively connected to the semiconductor switching elements 72u+, 72u-, 72v+, 72v-, 72w+ and 72w- in inverse parallel connection.

The semiconductor switching elements 72u+, 72u-, 72v+, 72v-, 72w+ and 72w- are turned on/off by the gate drive circuit 78, and supply a three-phase driving current having a phase difference of 120° to the stator coil 11 of the brushless motor 70. The brushless motor 70 generates a rotation magnetic field by the driving current supplied from the switching circuit 79 at the stator coil 11 and rotates the magnet rotor 12.

## Claims

1. An electrical circuit board to be connected to a motor, the electrical circuit board comprising:
wiring layers in which a current for driving a motor flows; and
a bolting through hole provided close to the wiring layers.

2. The electrical circuit board according to claim 1,
wherein the wiring layers are provided on opposite sides of the electrical circuit board.

3. A board device comprising:
a plurality of electrical circuit boards according to claim 2 that are arranged so that a bolting through hole of one of the plurality of electrical circuit boards is coaxially arranged with a bolting through hole of the other electrical circuit board; and
a conductive spacer arranged between the plurality of electrical circuit boards,
wherein opposite ends of the spacer are respectively connected to the wiring layers of the plurality of electrical circuit boards spaced apart from each other by the spacer.

4. A motor comprising:
a power terminal in the form of a nut.

5. A motor device comprising:
an electrical circuit board according to claim 1;
a motor including a power terminal in the form of a nut; and
a bolt threaded into the nut via a through hole of the electrical circuit board.

6. A motor device comprising:
a board device according to claim 3;
a motor that has a power terminal in the form of a nut; and
a bolt threaded into the nut via through holes of electrical circuit boards of the board device.

7. An electric pump comprising:
an electrical circuit board according to claim 1;
a motor including a power terminal in the form of a nut;
a bolt threaded into the nut via a through hole of the electrical circuit board; and
a pump driven by the motor.

8. An electric pump comprising:
the board device according to claim 3;
a motor that has a power terminal in the form of a nut;
a bolt threaded into the nut via through holes of electrical circuit boards of the board device; and
a pump driven by the motor.

9. A method of connecting a motor including a power terminal in the form of a nut and an electrical circuit board according to claim 1, the method comprising:
inserting a bolt into the through hole of the electrical circuit board; and
threading the bolt into the nut.

10. A method of connecting a motor including a power terminal in the form of a nut and a board device according to claim 3, the method comprising:
inserting a bolt via the through holes of the electrical circuit boards of the board device; and
threading the bolt into the nut.
